(19) Europäisches Patentamt
European Patent Office
Office européen des brevets

(11) EP 2 123 658 A1

(12) **EUROPEAN PATENT APPLICATION**
published in accordance with Art. 153(4) EPC

(43) Date of publication:
**25.11.2009 Bulletin 2009/48**

(21) Application number: **08711128.2**

(22) Date of filing: **12.02.2008**

(51) Int Cl.:
***C07F 7/18*** *(2006.01)*
***C09D 5/25*** *(2006.01)*
***C09D 183/06*** *(2006.01)*
***C23C 16/42*** *(2006.01)*
***H01L 21/316*** *(2006.01)*

(86) International application number:
**PCT/JP2008/052264**

(87) International publication number:
**WO 2008/099811 (21.08.2008 Gazette 2008/34)**

(84) Designated Contracting States:
**AT BE BG CH CY CZ DE DK EE ES FI FR GB GR HR HU IE IS IT LI LT LU LV MC MT NL NO PL PT RO SE SI SK TR**

(30) Priority: **14.02.2007 JP 2007033691**

(71) Applicant: **JSR Corporation**
**Tokyo 104-8410 (JP)**

(72) Inventors:
- **NAKAGAWA, Hisashi**
  **Tokyo 104-8410 (JP)**
- **NOBE, Youhei**
  **Tokyo 104-8410 (JP)**
- **KATOU, Hitoshi**
  **Tokyo 104-8410 (JP)**
- **ISHIZUKI, Kenji**
  **Tokyo 104-8410 (JP)**
- **KOKUBO, Terukazu**
  **Tokyo 104-8410 (JP)**

(74) Representative: **TBK-Patent**
**Bavariaring 4-6**
**80336 München (DE)**

# (54) MATERIAL FOR FORMING SILICON-CONTAINING FILM, AND SILICON-CONTAINING INSULATING FILM AND METHOD FOR FORMING THE SAME

(57) A silicon-containing film-forming material includes at least one organosilane compound shown by the following general formula (1).

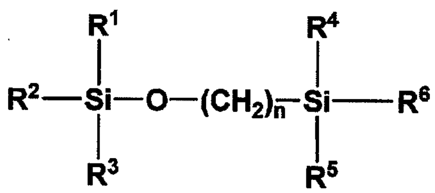

(1)

wherein $R^1$ to $R^6$ individually represent a hydrogen atom, an alkyl group having 1 to 4 carbon atoms, a vinyl group, a phenyl group, a halogen atom, a hydroxyl group, an acetoxy group, a phenoxy group, or an alkoxy group, provided that at least one of $R^1$ to $R^6$ represents a halogen atom, a hydroxyl group, an acetoxy group, a phenoxy group, or an alkoxy group, and n represents an integer from 0 to 3.

EP 2 123 658 A1

## Description

### TECHNICAL FIELD

The present invention relates to a silicon-containing film-forming material, a silicon-containing insulating film, and a method of forming the same.

### BACKGROUND ART

In recent years, an increase in processing speed has been strongly desired for ultra-large scale integrated (ULSI) circuits in order to deal with an increase in the processing of target information and the degree of functional complexity. An increase in ULSI processing speed has been implemented by reducing the size of elements provided in a chip, increasing the degree of integration of elements, and forming a multi-layer film. However, an increase in wiring resistance and wiring parasitic capacitance occurs due to a reduction in size of elements so that a wiring delay predominantly causes a signal delay of the entire device. In order to solve this problem, it is indispensable to use a low-resistivity wiring material or a low-dielectric-constant (low-k) interlayer dielectric material.

As a wiring material, Cu that is a low-resistivity metal has been studied and used instead of Al. As an interlayer dielectric material, a silica ($SiO_2$) film formed by a vacuum process such as chemical vapor deposition (CVD) has been widely used. Various proposals have been made to form a low-dielectric-constant (low-k) interlayer dielectric.

Examples of such a low-dielectric-constant interlayer dielectric include a porous silica film formed by reducing the film density of silica ($SiO_2$), an inorganic interlayer dielectric such as a silica film doped with F (FSG) and an SiOC film doped with C, and an organic interlayer dielectric such as a polyimide, polyarylene, and polyarylene ether.

A coating-type insulating film (SOG film) that contains a hydrolysis-condensation product of a tetraalkoxysilane as the main component, and an organic SOG film formed of a polysiloxane obtained by hydrolysis and condensation of an organic alkoxysilane, have also been proposed in order to form a more uniform interlayer dielectric.

An interlayer dielectric is formed as follows. An interlayer dielectric is generally formed by a coating method (spin coating method) or chemical vapor deposition (CVD). The coating method forms a film by applying an insulating film-forming polymer solution using a spin coater or the like. CVD introduces a reaction gas into a chamber and deposits a film utilizing a gas-phase reaction.

An inorganic material and an organic material have been proposed for the coating method and CVD. A film with excellent uniformity is generally obtained by the coating method. However, a film obtained by the coating method may exhibit inferior adhesion to a substrate or a barrier metal. A film obtained by CVD may exhibit poor uniformity or a dielectric constant that is not sufficiently reduced. On the other hand, an interlayer dielectric deposited by CVD has been widely used due to an operational advantage and excellent adhesion to a substrate. Therefore, CVD has an advantage over the coating method.

Various films obtained by CVD have been proposed. In particular, various films characterized by a silane compound used for a reaction have been proposed. For example, a film obtained using a dialkoxysilane (JP-A-11-288931 and JP-A-2002-329718), a film obtained using a cyclic silane compound (JP-T-2002-503879 and JP-T-2005-513766), and a film obtained using a silane compound in which a tertiary carbon atom or a secondary carbon atom is bonded to Si (JP-A-2004-6607 and JP-A-2005-51192) have been disclosed. A film having a low dielectric constant and excellent adhesion to a barrier metal or the like may be obtained using such a material.

However, such a silane compound may require extreme conditions during CVD due to chemical stability, or may undergo a reaction in a pipe connected to a chamber due to chemical instability, or may exhibit poor storage stability.

A deposited insulating film may exhibit high hygroscopicity depending on the selected compound so that a leakage current may increase. A semiconductor device production process generally involves a step that processes an interlayer dielectric using reactive ion etching (RIE). The dielectric constant of a film may increase during RIE, or an interlayer dielectric may be damaged by a fluorine acid-based chemical used in the subsequent washing step. Therefore, an interlayer dielectric having high process resistance has been desired.

A semiconductor wiring material that shows a low residual stress due to deposition has been desired along with an increase in the number of interlayer dielectric layers. If the interlayer dielectric has a high residual stress, adhesion to another thin film may deteriorate, or cracks may occur during a stacking process.

### DISCLOSURE OF THE INVENTION

The invention may provide a silicon-containing film-forming material that can be suitably used for semiconductor devices for which an increase in the degree of integration and the number of layers has been desired, is suitable for CVD in spite of chemical stability, and can form an interlayer dielectric that has excellent mechanical strength, a low relative dielectric constant, low hygroscopicity, high process resistance, and a low residual stress due to deposition.

The invention may also provide a silicon-containing insulating film that has excellent mechanical strength, a low relative dielectric constant, low hygroscopicity, and high process resistance, and a method of forming the same.

The inventors of the invention found that an interlayer dielectric that has a low relative dielectric constant, low hygroscopicity, high process resistance, and a low residual stress due to deposition can be formed using a silicon-containing film-forming material that includes an organosilane compound that has a specific structure with a silicon-oxygen-carbon-silicon skeleton.

The inventors also found that an interlayer dielectric that has a particularly low relative dielectric constant, low hygroscopicity, and high process resistance can be formed by incorporating an organosilane compound that has a specific structure with a silicon-carbon-silicon skeleton in the silicon-containing film-forming material.

According to one aspect of the invention, there is provided a silicon-containing film-forming material comprising at least one organosilane compound shown by the following general formula (1),

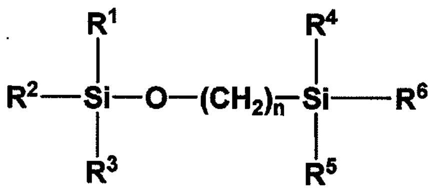

(1)

wherein $R^1$ to $R^6$ individually represent a hydrogen atom, an alkyl group having 1 to 4 carbon atoms, a vinyl group, a phenyl group, a halogen atom, a hydroxyl group, an acetoxy group, a phenoxy group, or an alkoxy group, provided that at least one of $R^1$ to $R^6$ represents a halogen atom, a hydroxyl group, an acetoxy group, a phenoxy group, or an alkoxy group, and n represents an integer from 0 to 3.

The above silicon-containing film-forming material may contain the organosilane compound shown by the general formula (1) in an amount of 0.1 to 70% (molar ratio).

The above silicon-containing film-forming material may further comprise at least one organosilane compound shown by the following general formula (2),

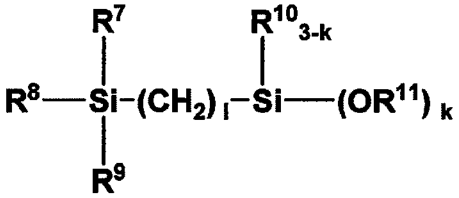

(2)

wherein $R^7$ to $R^9$ individually represent a hydrogen atom, an alkyl group having 1 to 4 carbon atoms, a vinyl group, a phenyl group, a halogen atom, a hydroxyl group, an acetoxy group, a phenoxy group, or an alkoxy group, $R^{10}$ individually represents a hydrogen atom, an alkyl group having 1 to 4 carbon atoms, a vinyl group, or a phenyl group, $R^{11}$ individually represents an alkyl group having 1 to 4 carbon atoms, an acetyl group, or a phenyl group, 1 represents an integer from 0 to 3, and k represents an integer from 0 to 2.

The above silicon-containing film-forming material may be used to form an insulating film that includes silicon, carbon, oxygen, and hydrogen.

The above silicon-containing film-forming material may have a content of elements other than silicon, carbon, oxygen, and hydrogen of less than 10 ppb, and a water content of less than 100 ppm.

According to another aspect of the invention, there is provided a silicon-containing insulating film formed using the above silicon-containing film-forming material.

The above silicon-containing insulating film may be formed by chemical vapor deposition.

According to another aspect of the invention, there is provided a method of forming a silicon-containing insulating film, the method comprising depositing the above silicon-containing film-forming material on a substrate by chemical vapor deposition to form a deposited film, and curing the deposited film by at least one means selected from heating,

electron beam irradiation, ultraviolet irradiation, and oxygen plasma irradiation.

According to another aspect of the invention, there is provided a compound shown by the following general formula (1),

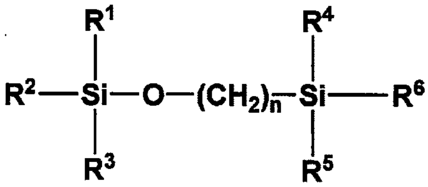

(1)

wherein $R^1$ to $R^6$ individually represent a hydrogen atom, an alkyl group having 1 to 4 carbon atoms, a vinyl group, a phenyl group, a halogen atom, a hydroxyl group, an acetoxy group, a phenoxy group, or an alkoxy group, provided that at least one of $R^1$ to $R^6$ represents a halogen atom, a hydroxyl group, an acetoxy group, a phenoxy group, or an alkoxy group, and n represents an integer from 0 to 3.

According to another aspect of the invention, there is provided a method of producing an organosilicon compound shown by the general formula (1), the method comprising reacting a compound 1 shown by the following general formula (3) with a compound 2 shown by the following general formula (4) in an atmosphere that contains oxygen,

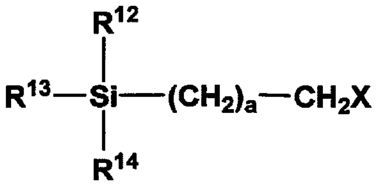

(3)

wherein $R^{12}$ to $R^{14}$ individually represent a hydrogen atom, an alkyl group having 1 to 4 carbon atoms, a vinyl group, a phenyl group, a halogen atom, a hydroxyl group, an acetoxy group, a phenoxy group, or an alkoxy group, X represents a halogen atom, and a represents an integer from 0 to 2,

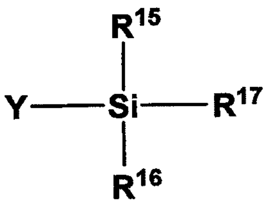

(4)

wherein at least one of $R^{15}$ to $R^{17}$ represents a hydrogen atom, an alkyl group having 1 to 4 carbon atoms, a vinyl group, a phenyl group, a halogen atom, a hydroxyl group, an acetoxy group, a phenoxy group, or an alkoxy group, at least one of $R^{15}$ to $R^{17}$ represents a halogen atom, a hydroxyl group, an acetoxy group, a phenoxy group, or an alkoxy group, and Y represents a halogen atom, a hydrogen atom, or an alkoxy group.

Since the above silicon-containing film-forming material includes the organosilane compound shown by the general formula (1), the silicon-containing film-forming material can be suitably used for semiconductor devices for which an increase in the degree of integration and the number of layers has been desired, is suitable for CVD in spite of chemical stability, and can be used to form an insulating film that has excellent mechanical strength, a low relative

dielectric constant, low hygroscopicity, high process resistance, and a low residual stress due to deposition. An insulating film that has a particularly low relative dielectric constant, low hygroscopicity, and high process resistance can be formed using the silicon-containing film-forming material that further includes the organosilane compound having a specific structure with a silicon-carbon-silicon skeleton.

The above silicon-containing insulating film has excellent mechanical strength, a low relative dielectric constant, and high process resistance.

An insulating film that has excellent mechanical strength, a low relative dielectric constant, and high process resistance can be obtained by the above method of forming a silicon-containing insulating film.

BEST MODE FOR CARRYING OUT THE INVENTION

The invention is described in detail below.

1. Silicon-containing film-forming material and method of producing the same

1.1. Silicon-containing film-forming material

A silicon-containing film-forming material according to one embodiment of the invention includes at least one organosilane compound shown by the following general formula (1).

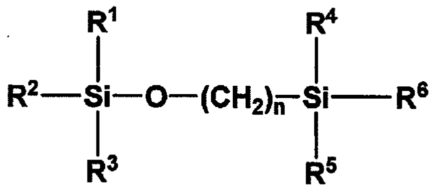

(1)

wherein $R^1$ to $R^6$ individually represent a hydrogen atom, an alkyl group having 1 to 4 carbon atoms, a vinyl group, a phenyl group, a halogen atom, a hydroxyl group, an acetoxy group, a phenoxy group, or an alkoxy group, provided that at least one of $R^1$ to $R^6$ represents a halogen atom, a hydroxyl group, an acetoxy group, a phenoxy group, or an alkoxy group, and n represents an integer from 0 to 3.

Specifically, the organosilane compound shown by the general formula (1) has a silicon-oxygen-carbon-silicon skeleton, wherein the substituents ($R^1$ to $R^6$) of each silicon atom represent a hydrogen atom, an alkyl group having 1 to 4 carbon atoms, a vinyl group, a phenyl group, a halogen atom, an acetoxy group, a hydroxyl group, or an alkoxy group having 1 to 4 carbon atoms, provided that at least one of $R^1$ to $R^6$ represents a halogen atom, a hydroxyl group, an acetoxy group, a phenoxy group, or an alkoxy group. Examples of the alkyl group having 1 to 4 carbon atoms include a methyl group, an ethyl group, an n-propyl group, an isopropyl group, an n-butyl group, an isobutyl group, a tert-butyl group, and the like.

In the organosilane compound shown by the general formula (1) that has a silicon-oxygen-carbon-silicon skeleton, all of the substituents ($R^1$ to $R^3$ or $R^4$ to $R^6$) of one of the silicon atoms preferably represent a hydrogen atom, an alkyl group having 1 to 4 carbon atoms, a vinyl group, or a phenyl group. It is particularly preferable that $R^4$ to $R^6$ represent a hydrogen atom, an alkyl group having 1 to 4 carbon atoms, a vinyl group, or a phenyl group. In this case, the silicon atom of the organosilane compound shown by the general formula (1) for which all of the substituents represent a hydrogen atom, an alkyl group having 1 to 4 carbon atoms, a vinyl group, or a phenyl group is considered to reduce damage caused by RIE and increase resistance to a fluorine acid-based chemical. It is particularly preferable that $R^1$ to $R^3$ or $R^4$ to $R^6$ individually represent a methyl group, a vinyl group, or a hydrogen atom.

The $Si-O-(CH_2)_n-Si$ site in the general formula (1) is considered to reduce the stress that occurs during deposition. In the general formula (1), at least one of $R^1$ to $R^6$ represents a halogen atom, a hydroxyl group, an acetoxy group, a phenoxy group, or an alkoxy group. These groups form an -Si-O-Si- bond to form a three-dimensional skeleton having a high degree of crosslinking so that an insulating film that has excellent mechanical strength, a low relative dielectric constant, high process resistance, and a low residual stress due to deposition can be formed.

In the organosilane compound shown by the general formula (1), it is preferable that n be an integer from 1 to 3 from the viewpoint of ensuring high process resistance and a residual stress due to deposition.

It is preferable that the silicon-containing film-forming material according to one embodiment of the invention

further include an organosilane compound shown by the following general formula (2).

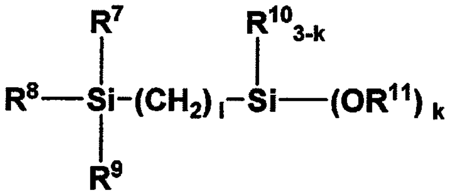

(2)

wherein $R^7$ to $R^9$ individually represent a hydrogen atom, an alkyl group having 1 to 4 carbon atoms, a vinyl group, a phenyl group, a halogen atom, a hydroxyl group, an acetoxy group, a phenoxy group, or an alkoxy group, $R^{10}$ individually represents a hydrogen atom, an alkyl group having 1 to 4 carbon atoms, a vinyl group, or a phenyl group, $R^{11}$ individually represents an alkyl group having 1 to 4 carbon atoms, an acetyl group, or a phenyl group, 1 represents an integer from 0 to 3, and k represents an integer from 0 to 2.

Examples of the alkyl group having 1 to 4 carbon atoms represented by $R^{10}$ in the general formula (2) include a methyl group, an ethyl group, an n-propyl group, an isopropyl group, an n-butyl group, an isobutyl group, a tert-butyl group, and the like. A methyl group, a vinyl group, and a hydrogen atom are particularly preferable as $R^7$ to $R^9$.

Examples of the alkyl group having 1 to 4 carbon atoms represented by $R^{11}$ in the general formula (2) include the alkyl groups mentioned for $R^7$ to $R^{10}$. A methyl group and an ethyl group are particularly preferable as $R^{11}$. In the general formula (2), 1 represents an integer from 1 to 3, and k represents 1 or 2.

Examples of the organosilane compounds shown by the general formula (2) in which 1=1 and k=1 include the following compounds.

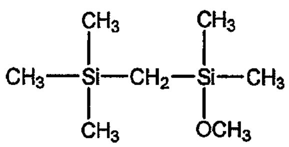 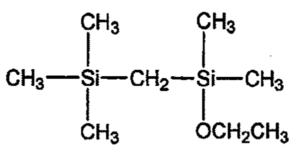 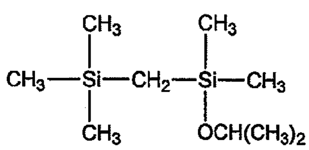

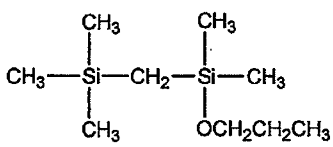 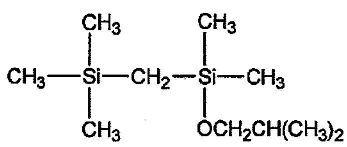 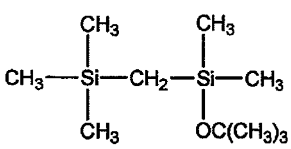

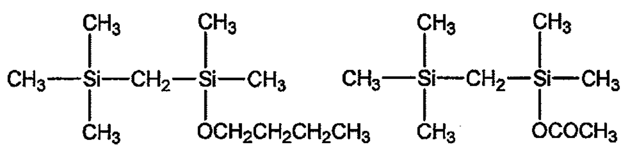 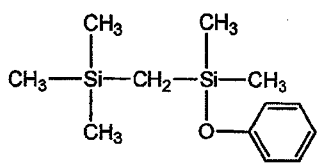

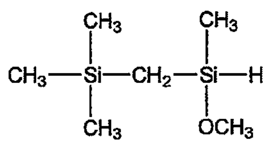 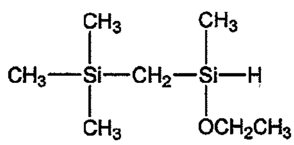 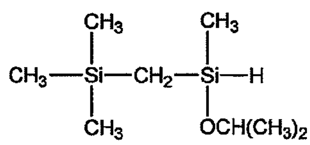

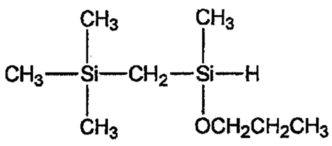 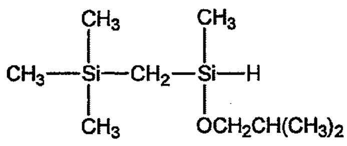 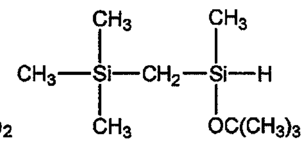

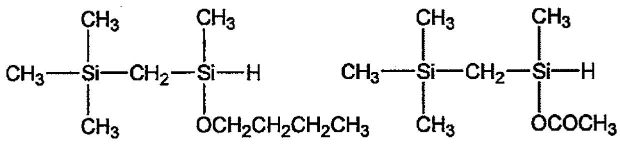 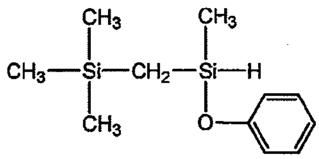

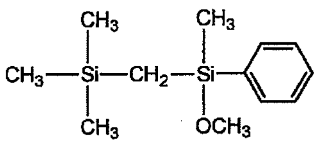 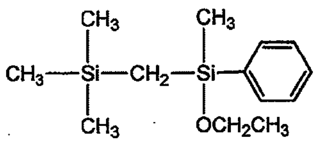 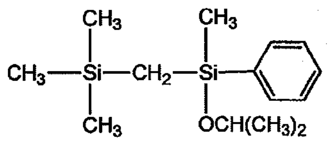

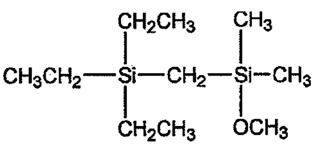 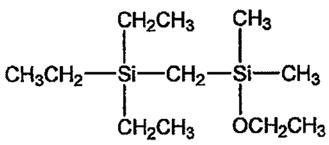 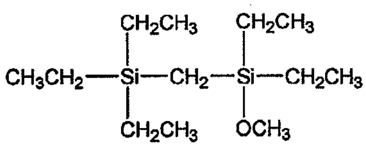

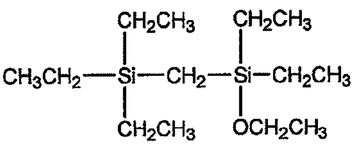 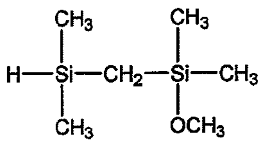 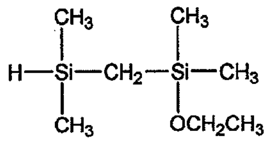

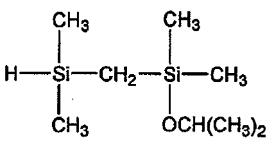 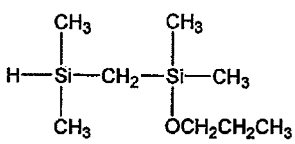 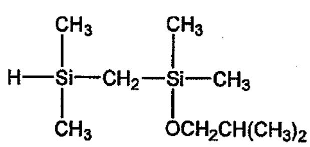

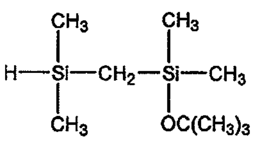 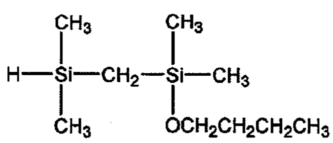 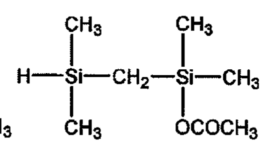

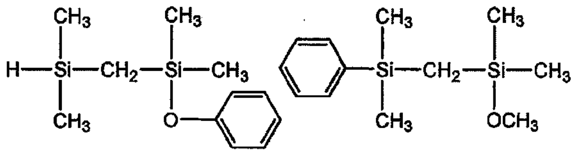
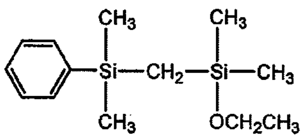

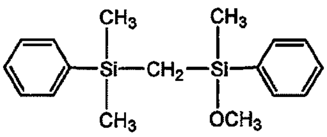
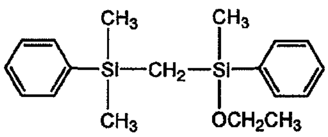
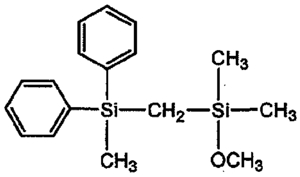

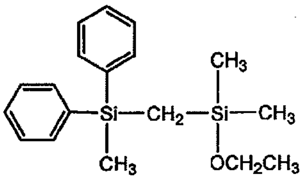
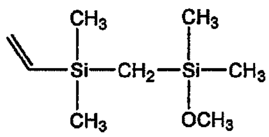
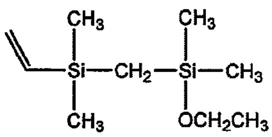

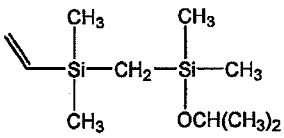
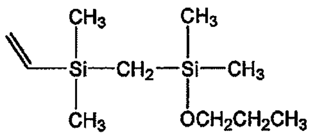
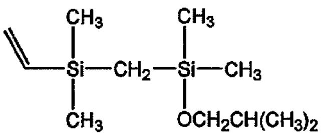

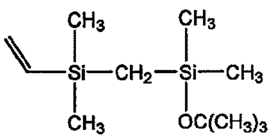
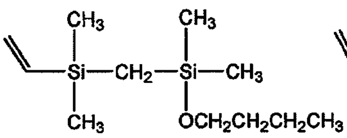
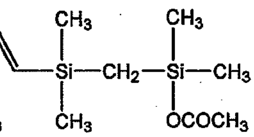

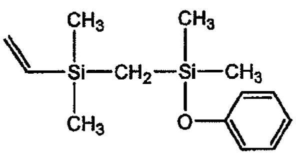

Examples of the organosilane compounds shown by the general formula (2) in which l=1 and k=2 include the following compounds.

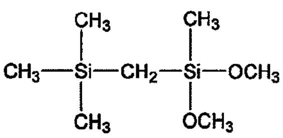
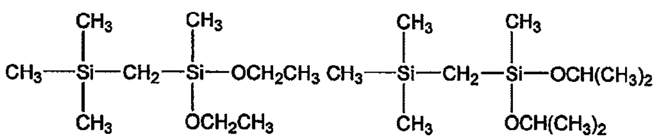

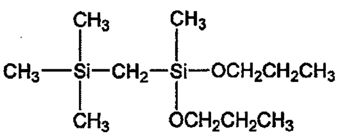
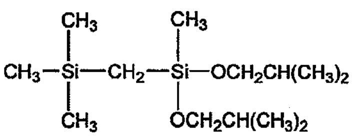
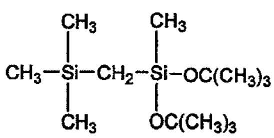

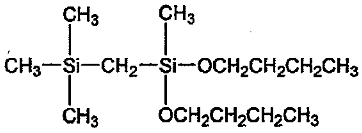 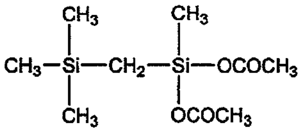 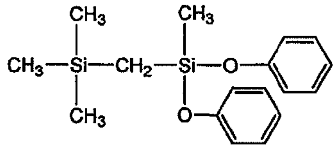

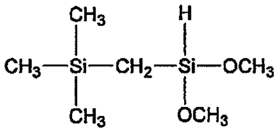 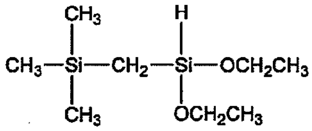 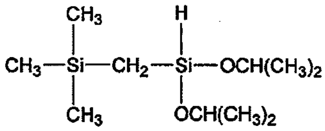

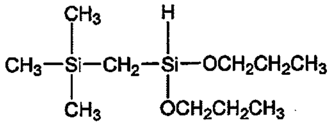 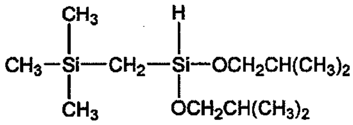 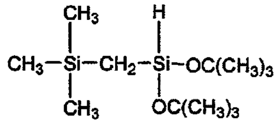

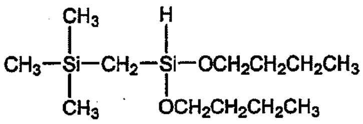 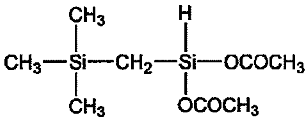 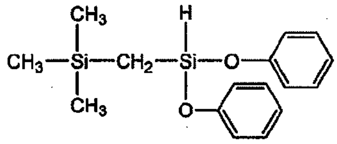

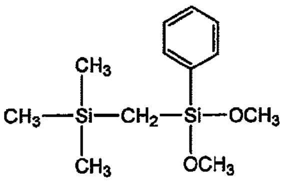 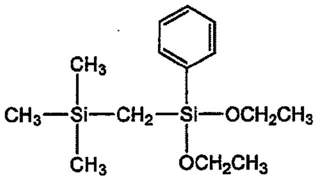 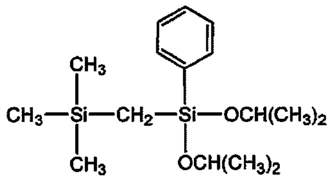

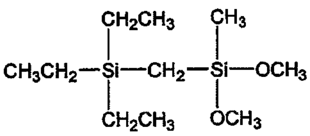 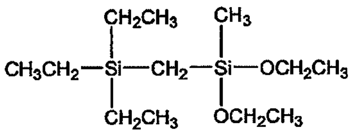 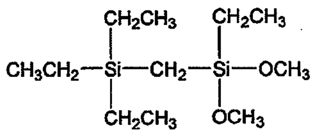

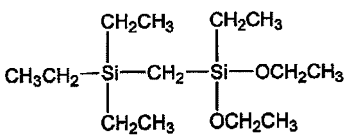 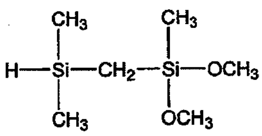 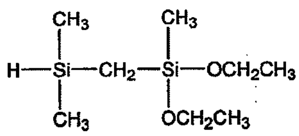

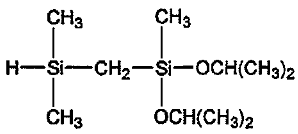 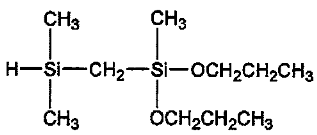 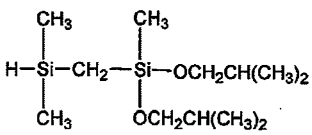

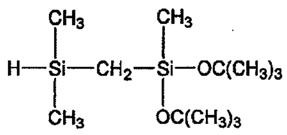
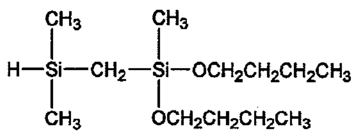
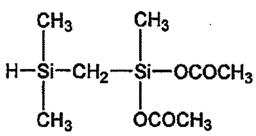

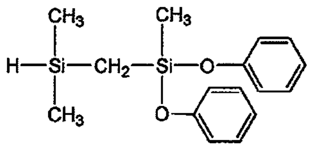
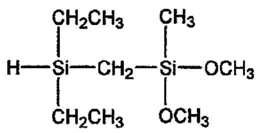
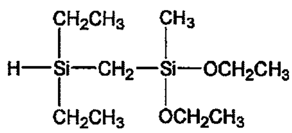

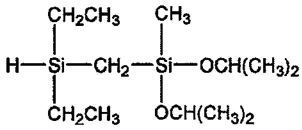
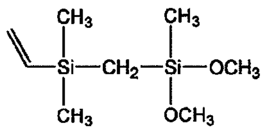
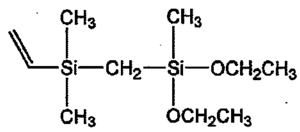

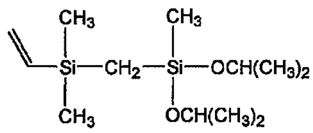
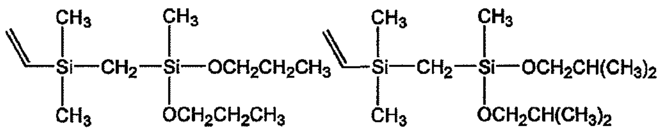

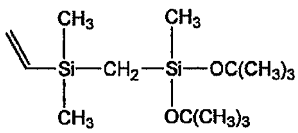
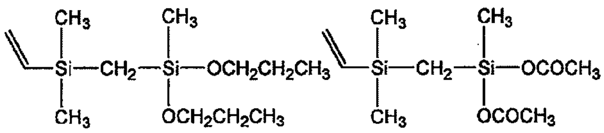

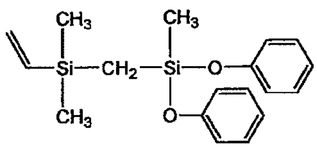
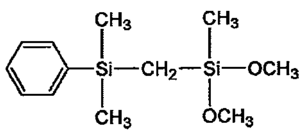
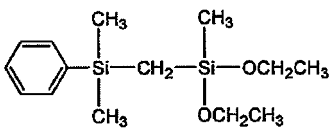

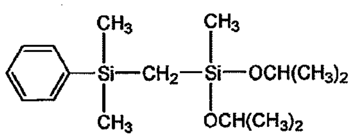

Examples of the organosilane compounds shown by the general formula (2) in which l=2 and k=1 include the following compounds.

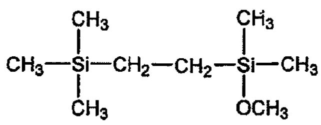
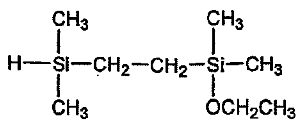
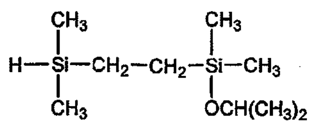

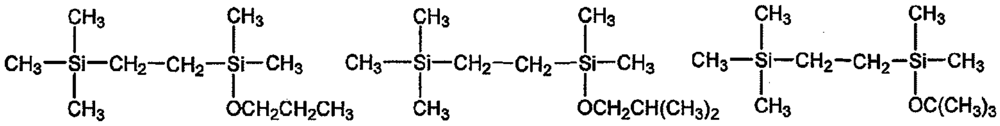

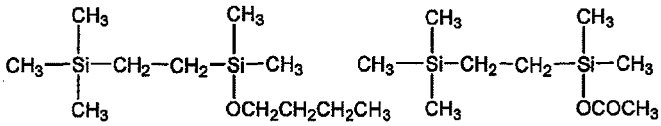

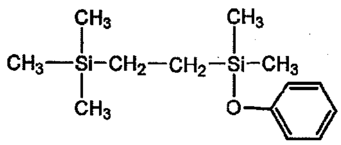

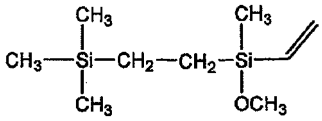

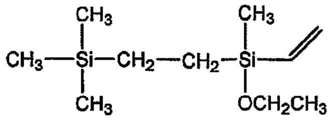

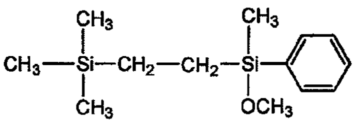

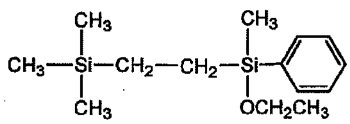

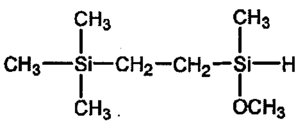

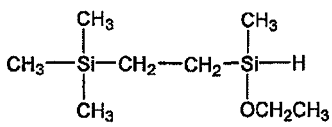

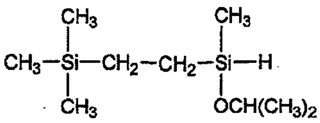

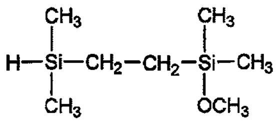

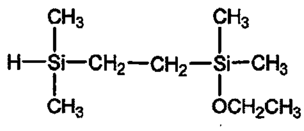

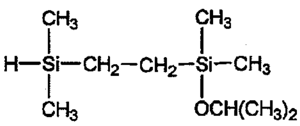

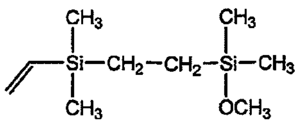

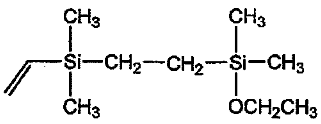

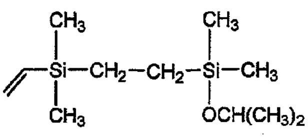

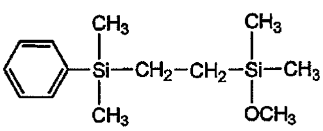

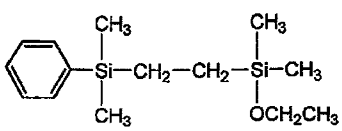

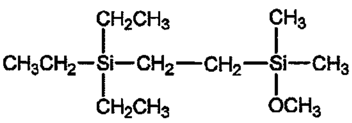

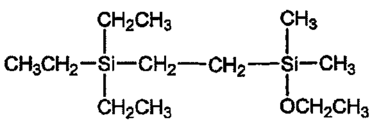

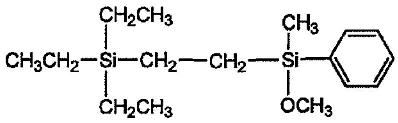
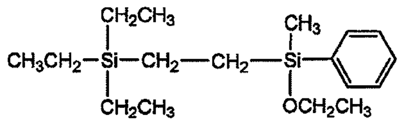

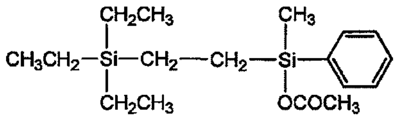

Examples of the organosilane compounds shown by the general formula (2) in which l=2 and k=2 include the following compounds.

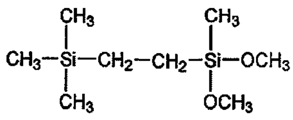
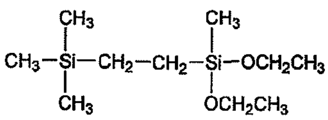
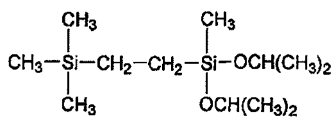

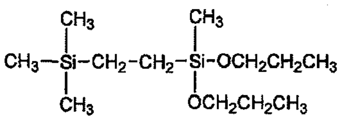
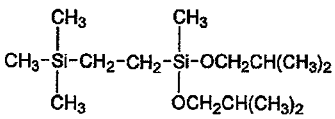
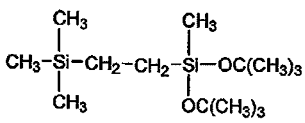

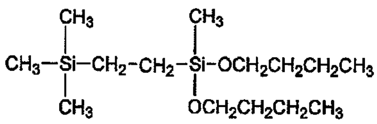
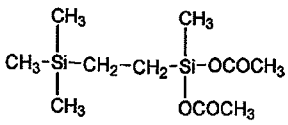
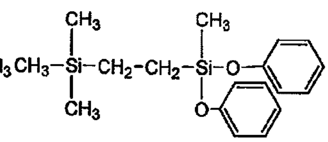

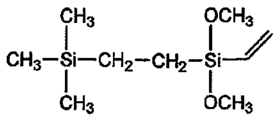
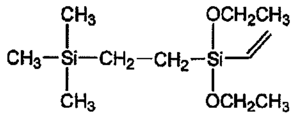
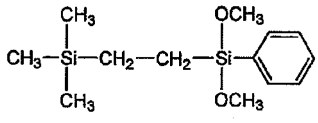

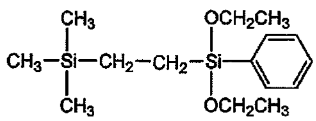
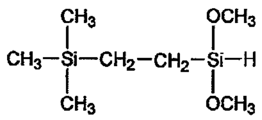
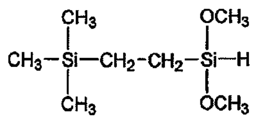

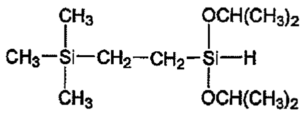
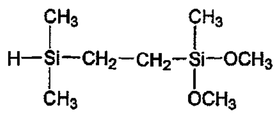
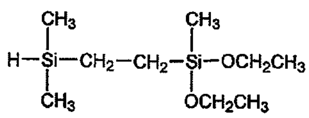

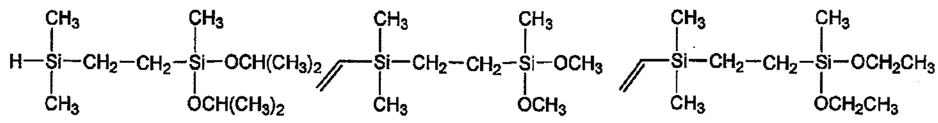

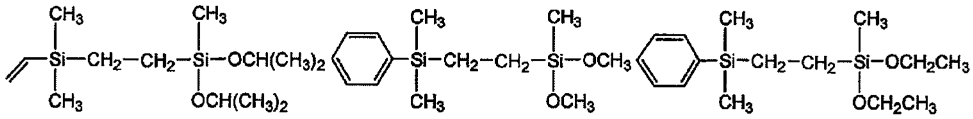

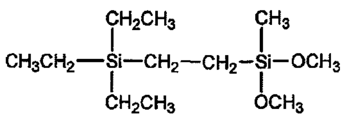

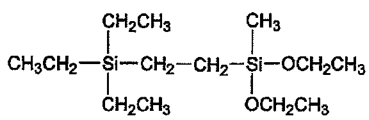

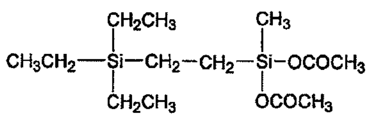

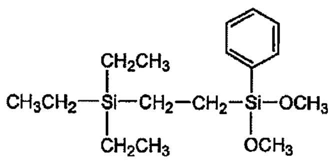

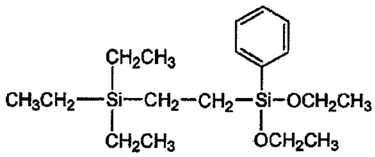

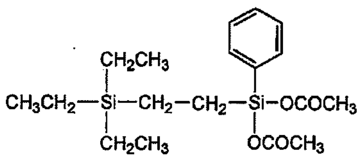

Examples of the organosilane compounds shown by the general formula (2) in which l=3 and k=1 include the following compounds.

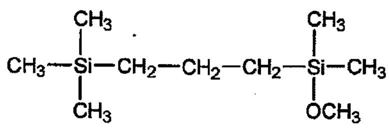

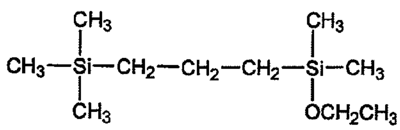

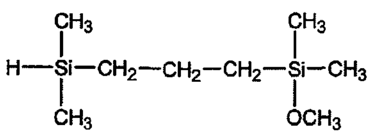

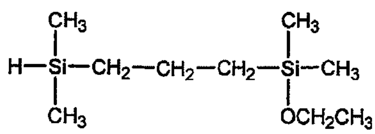

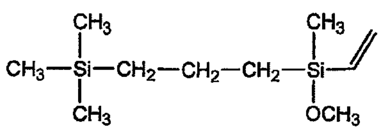

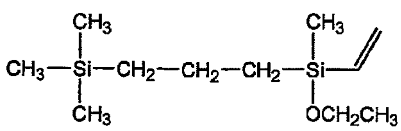

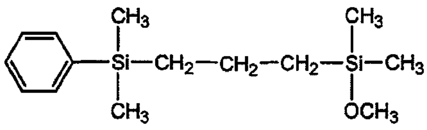 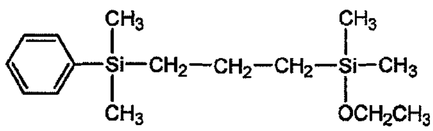

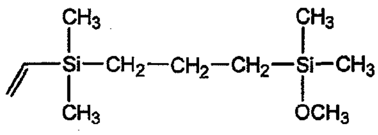 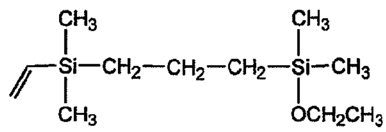

Examples of the organosilane compounds shown by the general formula (2) in which l=3 and k=2 include the following compounds.

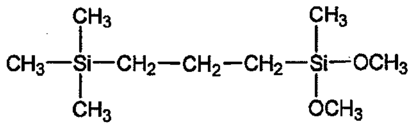 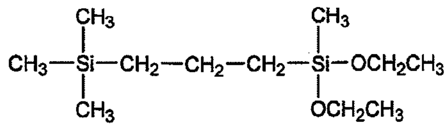

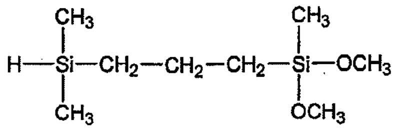 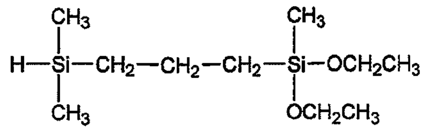

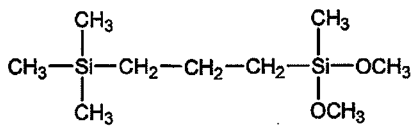 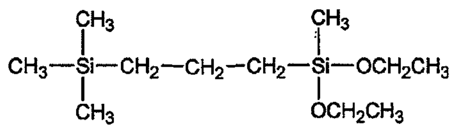

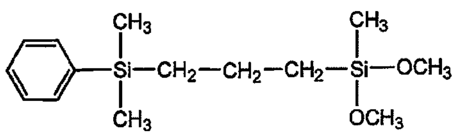 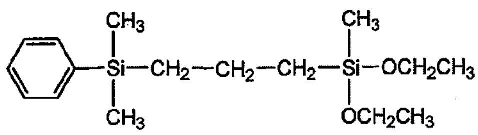

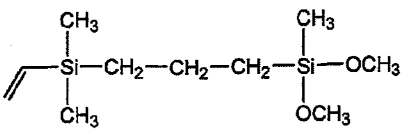 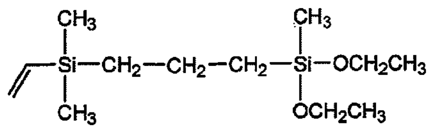

In the organosilane compound shown by the general formula (2), it is preferable that the total number of hydrogen atoms included in $R^7$ to $R^{10}$ be 0 to 2, and more preferably 0 or 1, from the viewpoint of ease of synthesis and purification and handling capability.

In the organosilane compound shown by the general formula (2), it is preferable that k be 1 or 2, and more preferably 2, from the viewpoint of the mechanical strength of the resulting silicon-containing film.

Specific examples of the organosilane compound shown by the general formula (1) are similar to the specific examples of the organosilane compound shown by the general formula (2), and include compounds having a structure in which an oxygen atom is present between one of the silicon atoms and the carbon atom (silicon-carbon bond) of the $Si-(CH_2)_1-Si$ skeleton in the general formula (2).

It is preferable that the silicon-containing film-forming material according to this embodiment mainly include

the organosilane compound shown by the general formula (1) and the organosilane compound shown by the general formula (2). Note that the silicon-containing film-forming material according to this embodiment may include components other than the organosilane compound shown by the general formula (1) and the organosilane compound shown by the general formula (2). It is preferable that the silicon-containing film-forming material according to this embodiment include the organosilane compound shown by the general formula (1) in an amount of 0.1 to 70 mol%, more preferably 0.1 to 50 mol%, still more preferably 0.5 to 30 mol%, still more preferably 0.8 to 15 mol%, and particularly preferably 1.0 to 15 mol%, based on the total amount of the silicon-containing film-forming material.

It is preferable that the silicon-containing film-forming material according to this embodiment include the organosilane compound shown by the general formula (2) in an amount of 30 mol% or more (normally 30 to 99.9 mol%, and preferably 50 to 99.9 mol%) based on the total amount of the silicon-containing film-forming material.

The ratio (molar ratio) of the organosilane compound shown by the general formula (2) to the organosilane compound shown by the general formula (1) is preferably $1\times10^{-3}$ to 10, and more preferably $5\times10^{-3}$ to 5.

In the silicon-containing film-forming material according to this embodiment, the total amount of the organosilane compound shown by the general formula (1) and the organosilane compound shown by the general formula (2) is preferably 95 mol% or more (preferably 99.0 mol% or more) based on the total amount of the silicon-containing film-forming material.

The silicon-containing film-forming material according to this embodiment may be used to form an insulating film that includes silicon, carbon, oxygen, and hydrogen. Such an insulating film exhibits high resistance to a hydrofluoric acid-based chemical that is widely used for a washing step during a semiconductor production process (i.e., exhibits high process resistance).

When using the silicon-containing film-forming material according to this embodiment as an insulating film-forming material, it is preferable that the silicon-containing film-forming material have a content of elements (hereinafter may be referred to as "impurities") other than silicon, carbon, oxygen, and hydrogen of less than 10 ppb, and a water content of less than 100 ppm. An insulating film that has a low relative dielectric constant and excellent process resistance can be obtained in high yield by forming an insulating film using such an insulating film-forming material.

1.2. Method of producing organosilane compound

A method of producing the organosilane compound shown by the general formula (1) and the organosilane compound shown by the general formula (2) is not particularly limited. For example, the organosilane compound shown by the general formula (1) and the organosilane compound shown by the general formula (2) may be produced by allowing an organosilane compound shown by the following general formula (3) and an organosilane compound shown by the following general formula (4) to undergo a coupling reaction in the presence of a metal.

The ratio of the organosilane compound shown by the general formula (1) to the organosilane compound shown by the general formula (2) produced by the reaction may be changed by appropriately adjusting the mixing ratio of the organosilane compound shown by the general formula (3) to the organosilane compound shown by the general formula (4), the reaction temperature, the reaction time, and the like. For example, the mixing ratio (molar ratio) of the organosilane compound shown by the general formula (4) to the organosilane compound shown by the general formula (3) is normally 0.1 to 50, preferably 0.5 to 20, and particularly preferably 0.8 to 10. The reaction temperature is normally 30 to 120°C, preferably 40 to 100°C, and particularly preferably 50 to 80°C. The reaction time is normally 0.1 to 100 hours, preferably 0.5 to 30 hours, and particularly preferably 1 to 10 hours. If the reaction time is less than 0.1 hours, the organosilane compound shown by the general formula (1) tends to be produced in an amount larger than that of the organosilane compound shown by the general formula (2). If the reaction time is more than 30 hours, the organosilane compound shown by the general formula (2) tends to be produced in an amount larger than that of the organosilane compound shown by the general formula (1).

The organosilane compound shown by the general formula (1) can be produced in an amount larger than that of the organosilane compound shown by the general formula (2) by carrying out the reaction in the presence of oxygen.

For example, the organosilane compound shown by the general formula (1) can be produced in an amount larger than that of the organosilane compound shown by the general formula (2) by blowing an oxygen-containing gas into the reaction system. Examples of the oxygen-containing gas include air, an oxygen gas, and a mixture of air and an oxygen gas. When blowing an oxygen-containing gas into the reaction system, the flow rate of the oxygen-containing gas per unit time with respect to the amount of reaction solution is preferably 0.01 to 10 l/min·l, and particularly preferably 0.1 to 1 l/min·l. The blowing time is preferably 1 to 60 minutes, and particularly preferably 5 to 30 minutes.

The expression "carrying out the reaction in the presence of oxygen" includes carrying out the reaction in an atmosphere other than an inert gas atmosphere (e.g., carrying out the reaction in air). In this case, the organosilane compound shown by the general formula (1) can also be produced.

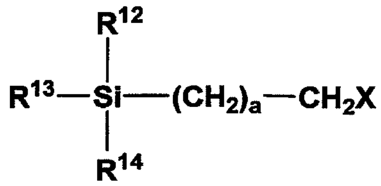

(3)

wherein $R^{12}$ to $R^{14}$ individually represent a hydrogen atom, an alkyl group having 1 to 4 carbon atoms, a vinyl group, a phenyl group, a halogen atom, a hydroxyl group, an acetoxy group, a phenoxy group, or an alkoxy group, X represents a halogen atom, and a represents an integer from 0 to 2.

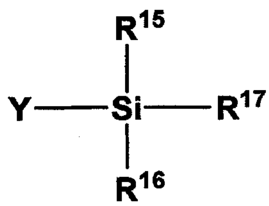

(4)

wherein at least one of $R^{15}$ to $R^{17}$ represents a hydrogen atom, an alkyl group having 1 to 4 carbon atoms, a vinyl group, a phenyl group, a halogen atom, a hydroxyl group, an acetoxy group, a phenoxy group, or an alkoxy group, at least one of $R^{15}$ to $R^{17}$ represents a halogen atom, a hydroxyl group, an acetoxy group, a phenoxy group, or an alkoxy group, and Y represents a halogen atom, a hydrogen atom, or an alkoxy group.

Examples of the alkyl group having 1 to 4 carbon atoms represented by $R^{12}$ to $R^{17}$ in the general formulas (3) and (4) include the alkyl groups having 1 to 4 carbon atoms mentioned for $R^1$ to $R^6$ in the general formula (1). Examples of the halogen atom represented by X and Y include a bromine atom and a chlorine atom.

2. Method of forming silicon-containing film

A method of forming a silicon-containing film (insulating film) according to one embodiment of the invention is preferably carried out by chemical vapor deposition (CVD), and particularly preferably plasma-enhanced CVD (PECVD). Specifically, the organosilane compound shown by the general formula (1) is vaporized in a PECVD apparatus using a vaporizer, and introduced into a deposition chamber. Plasma is generated by applying a voltage between electrodes provided in the deposition chamber from a high-frequency power supply to form a plasma CVD film on a substrate disposed in the deposition chamber.

Examples of the substrate on which the silicon-containing film according to this embodiment is formed include Si-containing layers formed of Si, $SiO_2$, SiN, SiC, SiCN, and the like. A gas such as argon or helium and an oxidizing agent such as oxygen or nitrous oxide may be introduced into the deposition chamber in order to generate plasma. A thin film (deposited film) suitable as a low-dielectric-constant material for semiconductor devices can be formed by depositing a film using the silicon-containing film-forming material according to this embodiment utilizing the PECVD apparatus.

A plasma generation method using the PECVD apparatus is not particularly limited. For example, inductively-coupled plasma, capacitively-coupled plasma, ECR plasma, or the like may be used.

It is preferable that the silicon-containing deposited film thus obtained have a thickness of 0.05 to 5.0 micrometers. The deposited film is then cured to form a silicon-containing film (insulating film).

The deposited film may be cured by at least one means selected from heating, electron beam irradiation, ultraviolet irradiation, and oxygen plasma irradiation.

When curing the deposited film by heating, the deposited film formed by CVD is heated to 80 to 450°C in an inert atmosphere or under reduced pressure, for example. The deposited film may be heated using a hot plate, an oven, a furnace, or the like. The heating atmosphere may be an inert atmosphere or an atmosphere under reduced pressure.

In order to control the curing speed of the deposited film, the deposited film may be heated stepwise, or the atmosphere may be selected from nitrogen, air, oxygen, and an atmosphere under reduced pressure, if necessary. A silicon-containing film can be formed by the above-described steps.

3. Silicon-containing film

A silicon-containing film according to one embodiment of the invention may be obtained by the above-described film-forming method.

Since the silicon-containing film according to this embodiment has a low dielectric constant and excellent surface flatness, the silicon-containing film is particularly useful for an interlayer dielectric for semiconductor devices such as an LSI, a system LSI, a DRAM, an SDRAM, an RDRAM, and a D-RDRAM. The silicon-containing film may also be suitably used as an etching stopper film, a protective film (e.g., surface coating film) for semiconductor devices, an intermediate layer used in a semiconductor production process utilizing a multilayer resist, an interlayer dielectric for multilayered wiring boards, a protective film and an insulating film for liquid crystal display devices, and the like. The silicon-containing film according to this embodiment is also suitable for semiconductor devices formed using a copper damascene process, for example.

Since the silicon-containing film according to this embodiment is formed using the above-mentioned silicon-containing film-forming material, the silicon-containing film has an $-Si-O-(CH_2)_n-O-$ site (wherein n represents an integer from 0 to 3). Since the silicon-containing film according to this embodiment that includes the $-Si-O-(CH_2)_n-O-$ site has excellent chemical resistance and suppresses an increase in relative dielectric constant during a production process, the silicon-containing film has a low relative dielectric constant and excellent process resistance.

The silicon-containing film according to this embodiment preferably has a relative dielectric constant of 3.0 or less, more preferably 1.8 to 3.0, and still more preferably 2.2 to 3.0.

The silicon-containing film according to this embodiment preferably has a modulus of elasticity of 4.0 to 15.0 GPa, and more preferably 4.0 to 12.0 GPa. The silicon-containing film according to this embodiment preferably has a hardness of 0.1 GPa or more, and more preferably 0.5 GPa or more. Therefore, the silicon-containing film according to this embodiment has excellent insulating film properties (e.g., mechanical strength and relative dielectric constant).

4. Examples

The invention is further described below by way of examples. Note that the invention is not limited to the following examples. In the examples and comparative examples, the units "part" and "%" respectively refer to "part by weight" and "wt%" unless otherwise indicated.

4.1. Evaluation method

Various properties were evaluated as follows.

4.1.1. Impurity content of organosilane compound

The water content and the impurity content of the purified organosilane compound were measured using a Karl Fisher aquacounter ("AQ-7" manufactured by Hiranuma Sangyo Co., Ltd.) and an atomic absorption spectrophotometer (polarized Zeeman atomic absorption spectrophotometer "Z-5700" manufactured by Hitachi High-Technologies Corporation).

4.1.2. Relative dielectric constant

A silicon-containing insulating film was formed on an eight-inch silicon wafer by PECVD under conditions described later. An aluminum electrode pattern was formed on the resulting film by a deposition method to prepare a relative dielectric constant measurement sample. The relative dielectric constant of the sample (insulating film) was measured by a CV method at a frequency of 100 kHz using an electrode "HP16451B" and a precision LCR meter "HP4284A" manufactured by Yokogawa Hewlett-Packard. The difference between the relative dielectric constant (k@RT) measured at a temperature of 24°C and a relative humidity of 40%RH and the relative dielectric constant (k@200°C) measured at a temperature of 200°C in a dry nitrogen atmosphere is referred to as deltak (deltak=k@RT-k@200°C). An increase in relative dielectric constant due to moisture absorption of the film can be evaluated based on the value deltak. An organic silica film having a value deltak of 0.15 or more is generally considered to have high moisture absorption properties. 4.1.3. Hardness and modulus of elasticity (Young's modulus) of insulating film

A Berkovich indenter was installed in a nanohardness tester ("Nanoindenter XP" manufactured by MTS), and

the universal hardness of the resulting insulating film was measured. The modulus of elasticity was measured using a continuous stiffness measurement method.

4.1.4. Residual stress of film

The residual stress of the film was measured by the following method.
Specifically, warping of the substrate was measured before and after deposition using a laser utilizing a measuring instrument "FLEX-2320" (manufactured by KLA).

4.1.5. Storage stability

The purity of the organosilane compound stored at 40°C for 30 days was measured by GC (instrument: "6890N" manufactured by Agilent Technologies, column: "SPB-35" manufactured by Supelco). When a change in purity due to storage was less than 0.5%, the storage stability was evaluated as good.

4.1.6. Chemical resistance

An eight-inch wafer on which a silicon-containing insulating film was formed was immersed in a 0.2% diluted hydrofluoric acid aqueous solution at room temperature for three minutes to observe a change in thickness of the silicon-containing insulating film due to immersion. The chemical resistance was evaluated as good when the residual film rate defined below was 99% or more.

$$\text{Residual film rate (\%)} = \text{(thickness after immersion)} / \text{(thickness before immersion)} \times 100$$

A: The residual film rate was 99% or more.
B: The residual film rate was less than 99%.

4.2. Production of silicon-containing film-forming material

4.2.1. Synthesis Example 1

A three-necked flask equipped with a cooling condenser and a dropping funnel was dried at 50°C under reduced pressure. After the addition of 20 g of magnesium and 500 ml of THF to the flask, 25 g of (chloromethyl)trimethylsilane was added to the mixture with stirring at room temperature. After continuously stirring the mixture and confirming generation of heat, 55 g of (chloromethyl)trimethylsilane was added to the mixture from the dropping funnel over 30 minutes. After the addition, the mixture was allowed to cool to room temperature. A mixed liquid of 250 ml of THF and 237 g of methyltrimethoxysilane was then added to the flask. The mixture was then refluxed with heating at 70°C for six hours to complete the reaction. After cooling the reaction liquid to room temperature, magnesium salts produced and unreacted magnesium were filtered out. The filtrate was then fractionated to obtain a composition A containing 75 g of [(trimethylsilyl)methyl]methyldimethoxysilane (yield: 70 mol%) and 1.2 g of [(trimethylsilyl)methoxy]methyldimethoxysilane (yield: 0.9 mol%) (confirmed by GC). The content of compounds other than the above-mentioned compounds was 1.0 mol% or less based on the total amount of the composition A (confirmed by GC). The residual water content was 80 ppm. The content (metal impurity content) of elements other than silicon, carbon, oxygen, and hydrogen was as follows. Specifically, the Na content was 1.5 ppb, the K content was 1.1 ppb, and the Fe content was 1.7 ppb. The content of each of Li, Mg, Cr, Ag, Cu, Zn, Mn, Co, Ni, Ti, Zr, Al, Pb, Sn, and W was equal to or less than the detection limit (0.2 ppb). It was confirmed that the organosilane compound obtained by Synthesis Example 1 had a purity sufficient for an insulating film-forming material.

4.2.2. Synthesis Example 2

A three-necked flask equipped with a cooling condenser and a dropping funnel was dried at 50°C under reduced pressure. After the addition of 20 g of magnesium and 500 ml of THF to the flask, 25 g of (chloromethyl)trimethylsilane was added to the mixture with stirring at room temperature. After continuously stirring the mixture and confirming generation of heat, 55 g of (chloromethyl)trimethylsilane was added to the mixture from the dropping funnel over 30 minutes. After the addition, the mixture was allowed to cool to room temperature. A mixed liquid of 250 ml of THF and 258 g of vinyltrimethoxysilane was then added to the flask. The mixture was then refluxed with heating at 70°C for six hours to complete the reaction. After cooling the reaction liquid to room temperature, magnesium salts produced and unreacted magnesium were filtered out. The filtrate was then fractionated to obtain a composition B containing 80 g of [(trimethylsilyl) methyl]vinyldimethoxysilane (yield: 65 mol%) and 2.3 g of [(trimethylsilyl)methoxy]vinyldimethoxysilane (yield: 1.6 mol%) (confirmed by GC). The content of compounds other than the above-mentioned compounds was 1.0 mol% or less based on the total amount of the composition B (confirmed by GC). The residual water content was 70 ppm. The content (metal impurity content) of elements other than silicon, carbon, oxygen, and hydrogen was as follows. Specifically, the Na content was 1.5 ppb, the K content was 0.9 ppb, and the Fe content was 0.7 ppb. The content of each of Li, Mg, Cr, Ag, Cu, Zn, Mn, Co, Ni, Ti, Zr, Al, Pb, Sn, and W was equal to or less than the detection limit (0.2 ppb). It was confirmed that the organosilane compound obtained by Synthesis Example 2 had a purity sufficient for an insulating film-forming material.

4.2.3. Synthesis Example 3

A three-necked flask equipped with a cooling condenser and a dropping funnel was dried at 50°C under reduced pressure. After the addition of 20 g of magnesium and 500 ml of THF to the flask, 25 g of (chloroethyl)triethylsilane was added to the mixture with stirring at room temperature. After continuously stirring the mixture and confirming generation of heat, 91 g of (chloroethyl)triethylsilane was added to the mixture from the dropping funnel over 30 minutes. After the addition, the mixture was allowed to cool to room temperature. A mixed liquid of 250 ml of THF and 375 g of ethyltriethoxysilane was then added to the flask. The mixture was then refluxed with heating at 70°C for six hours to complete the reaction. After cooling the reaction liquid to room temperature, magnesium salts produced and unreacted magnesium were filtered out. The filtrate was then fractionated to obtain a composition C containing 113 g of [(triethylsilyl)ethyl] ethyldiethoxysilane (yield: 60 mol%) and 1.9 g of [(triethylsilyl)ethoxy]ethyldiethoxysilane (yield: 1.0 mol%) (confirmed by GC). The content of compounds other than the above-mentioned compounds was 1.0 mol% or less based on the total amount of the composition C (confirmed by GC). The residual water content was 85 ppm. The content (metal impurity content) of elements other than silicon, carbon, oxygen, and hydrogen was as follows. Specifically, the Na content was 1.1 ppb, the K content was 0.5 ppb, and the Fe content was 0.4 ppb. The content of each of Li, Mg, Cr, Ag, Cu, Zn, Mn, Co, Ni, Ti, Zr, Al, Pb, Sn, and W was equal to or less than the detection limit (0.2 ppb). It was confirmed that the organosilane compound obtained by Synthesis Example 3 had a purity sufficient for an insulating film-forming material.

4.2.4. Synthesis Example 4

A three-necked flask equipped with a cooling condenser and a dropping funnel was dried at 50°C under reduced pressure. After the addition of 20 g of magnesium and 500 ml of THF to the flask, 25 g of (chloromethyl)trimethylsilane was added to the mixture with stirring at room temperature. After continuously stirring the mixture and confirming generation of heat, 55 g of (chloromethyl)trimethylsilane was added to the mixture from the dropping funnel over 30 minutes. After the addition, the mixture was allowed to cool to room temperature. Then, dry compressed air (manufactured by Taiyo Nippon Sanso Corporation) was bubbled into the flask for five minutes at a flow rate of 0.1 l/min while cooling the flask in an ice bath. After bubbling, a mixed liquid of 250 ml of THF and 237 g of methyltrimethoxysilane was added to the flask. The mixture was then refluxed with heating at 70°C for six hours to complete the reaction. After cooling the reaction liquid to room temperature, magnesium salts produced and unreacted magnesium were filtered out. The filtrate was then fractionated to obtain a composition D containing 45.0 g of [(trimethylsilyl)methyl]methyldimethoxysilane (yield: 42 mol%) and 15 g of [(trimethylsilyl)methoxy]methyldimethoxysilane (yield: 11.3 mol%) (confirmed by GC). The content of compounds other than the above-mentioned compounds was 1.0 mol% or less based on the total amount of the composition C (confirmed by GC). The residual water content was 30 ppm. The content (metal impurity content) of elements other than silicon, carbon, oxygen, and hydrogen was as follows. Specifically, the Na content was 2.4 ppb, the K content was 1.0 ppb, and the Fe content was 1.2 ppb. The content of each of Li, Mg, Cr, Ag, Cu, Zn, Mn, Co, Ni, Ti, Zr, Al, Pb, Sn, and W was equal to or less than the detection limit (0.2 ppb). It was confirmed that the organosilane compound obtained by Synthesis Example 4 had a purity sufficient for an insulating film-forming material.

4.2.5. Synthesis Example 5

A three-necked flask equipped with a cooling condenser and a dropping funnel was dried at 50°C under reduced pressure. After the addition of 20 g of magnesium and 500 ml of THF to the flask, 25 g of (chloromethyl)trimethylsilane was added to the mixture with stirring at room temperature. After continuously stirring the mixture and confirming generation of heat, 55 g of (chloromethyl)trimethylsilane was added to the mixture from the dropping funnel over 30 minutes. After the addition, the mixture was allowed to cool to room temperature. Then, dry compressed air (manufactured by Taiyo Nippon Sanso Corporation) was bubbled into the flask for 15 minutes at a flow rate of 0.5 l/min while cooling the flask in an ice bath. After bubbling, a mixed liquid of 250 ml of THF and 258 g of vinyltrimetoxysilane was added dropwise to the flask. The mixture was then refluxed with heating at 70°C for six hours to complete the reaction. After cooling the reaction liquid to room temperature, magnesium salts produced and unreacted magnesium were filtered out. The filtrate was then fractionated to obtain a composition E containing 42.0 g of [(trimethylsilyl)methyl]vinyldimethoxysilane (yield: 34.3 mol%) and 57.5 g of [(trimethylsilyl)methoxy]vinyldimethoxysilane (yield: 40.0 mol%) (confirmed by GC). The content of compounds other than the above-mentioned compounds was 1.0 mol% or less based on the total amount of the composition C (confirmed by GC). The residual water content was 80 ppm. The content (metal impurity content) of elements other than silicon, carbon, oxygen, and hydrogen was as follows. Specifically, the Na content was 1.4 ppb, the K content was 2.9 ppb, and the Fe content was 3.8 ppb. The content of each of Li, Mg, Cr, Ag, Cu, Zn, Mn, Co, Ni, Ti, Zr, Al, Pb, Sn, and W was equal to or less than the detection limit (0.2 ppb). It was confirmed that the organosilane compound obtained by Synthesis Example 5 had a purity sufficient for an insulating film-forming material.

4.3. Film formation

4.3.1. Example 1

A silicon-containing film (1-1) (thickness: 0.5 micrometers) was deposited on a silicon substrate by plasma CVD using a plasma CVD apparatus "PD-220N" (manufactured by SAMCO, Inc.) at a composition A gas flow rate of 25 sccm, an Ar gas flow rate of 3 sccm, an RF power of 250 W, a substrate temperature of 380°C, and a reaction pressure of 10 Torr.

4.3.2. Example 2

A silicon-containing film (1-2) (thickness: 0.5 micrometers) was deposited on a silicon substrate in the same manner as in Example 1, except for using the composition B as the silica source.

4.3.3. Example 3

A silicon-containing film (1-3) (thickness: 0.5 micrometers) was deposited on a silicon substrate in the same manner as in Example 1, except for using the composition C as the silica source.

4.3.4. Example 4

A silicon-containing film (1-4) (thickness: 0.5 micrometers) was deposited on a silicon substrate in the same manner as in Example 1, except for using the composition D as the silica source.

4.3.5. Example 5

A silicon-containing film (1-5) (thickness: 0.5 micrometers) was deposited on a silicon substrate in the same manner as in Example 1, except for using the composition E as the silica source.

4.3.6. Comparative Example 1

A silicon-containing film (2) (thickness: 500 nm) was deposited on a silicon substrate in the same manner as in Example 1, except for using dimethoxydimethylsilane as the silica source.

4.3.7. Comparative Example 2

A silicon-containing film (2-2) (thickness: 500 nm) was deposited on a silicon substrate in the same manner as in Example 1, except for using divinyldimethoxysilane as the silica source.

The evaluation results of the silicon-containing films obtained in the examples and the comparative examples are shown in Table 1.

TABLE 1

| | Relative dielectric constant | deltak | Hardness (GPa) | Modulus of elasticity (GPa) | Residual stress (Mpa) | Storage stability | Chemical resistance |
|---|---|---|---|---|---|---|---|
| Example 1 | 2.47 | 0.11 | 0.8 | 8.6 | 25 | Good | A |
| Example 2 | 2.43 | 0.12 | 0.9 | 9.3 | 23 | Good | A |
| Example 3 | 2.43 | 0.13 | 0.8 | 8.3 | 19 | Good | A |
| Example 4 | 2.47 | 0.12 | 1.0 | 10.5 | 17 | Good | A |
| Example 5 | 2.48 | 0.11 | 1.2 | 11.4 | 14 | Good | A |
| Comparative Example 1 | 2.55 | 0.17 | 0.7 | 7.7 | 35 | Good | B |
| Comparative Example 2 | 2.50 | 0.18 | 0.7 | 7.5 | 31 | Good | B |

The silicon-containing films obtained in Examples 1 to 5 had excellent mechanical strength, a low residual stress, a small value deltak (i.e., an index of relative dielectric constant and hygroscopicity), excellent chemical resistance, and excellent storage stability. On the other hand, the films obtained in Comparative Examples 1 and 2 had low mechanical strength, a high relative dielectric constant, a large value deltak, and low chemical resistance as compared with the films obtained in Examples 1 to 3.

As described above, since the silicon-containing film according to the invention has excellent mechanical strength, a low residual stress, a low relative dielectric constant, excellent hygroscopic resistance, excellent chemical resistance, and excellent storage stability, the silicon-containing film according to the invention can be suitably used as an interlayer dielectric of semiconductor devices and the like.

## Claims

**1.** A silicon-containing film-forming material comprising at least one organosilane compound shown by the following general formula (1),

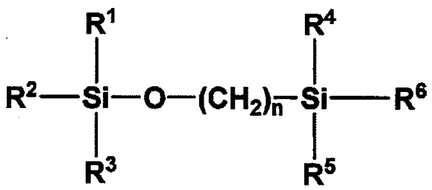

(1)

wherein $R^1$ to $R^6$ individually represent a hydrogen atom, an alkyl group having 1 to 4 carbon atoms, a vinyl group, a phenyl group, a halogen atom, a hydroxyl group, an acetoxy group, a phenoxy group, or an alkoxy group, provided that at least one of $R^1$ to $R^6$ represents a halogen atom, a hydroxyl group, an acetoxy group, a phenoxy group, or an alkoxy group, and n represents an integer from 0 to 3.

**2.** The silicon-containing film-forming material according to claim 1, the material containing the organosilane compound shown by the general formula (1) in an amount of 0.1 to 70% (molar ratio).

**3.** The silicon-containing film-forming material according to claim 1 or 2, further comprising at least one organosilane compound shown by the following general formula (2),

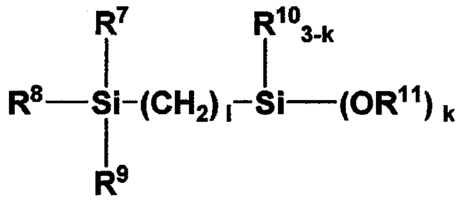

(2)

wherein $R^7$ to $R^9$ individually represent a hydrogen atom, an alkyl group having 1 to 4 carbon atoms, a vinyl group, a phenyl group, a halogen atom, a hydroxyl group, an acetoxy group, a phenoxy group, or an alkoxy group, $R^{10}$ individually represents a hydrogen atom, an alkyl group having 1 to 4 carbon atoms, a vinyl group, or a phenyl group, $R^{11}$ individually represents an alkyl group having 1 to 4 carbon atoms, an acetyl group, or a phenyl group, 1 represents an integer from 0 to 3, and k represents an integer from 0 to 2.

**4.** The silicon-containing film-forming material according to any one of claims 1 to 3, the material being used to form an insulating film that includes silicon, carbon, oxygen, and hydrogen.

**5.** The silicon-containing film-forming material according to any one of claims 1 to 4, the material having a content of elements other than silicon, carbon, oxygen, and hydrogen of less than 10 ppb, and a water content of less than 100 ppm.

**6.** A silicon-containing insulating film formed using the silicon-containing film-forming material according to any one of claims 1 to 5.

**7.** The silicon-containing insulating film according to claim 6, the film being formed by chemical vapor deposition.

**8.** A method of forming a silicon-containing insulating film, the method comprising: depositing the silicon-containing film-forming material according to any one of claims 1 to 5 on a substrate by chemical vapor deposition to form a deposited film; and curing the deposited film by at least one means selected from heating, electron beam irradiation, ultraviolet irradiation, and oxygen plasma irradiation.

**9.** A compound shown by the following general formula (1),

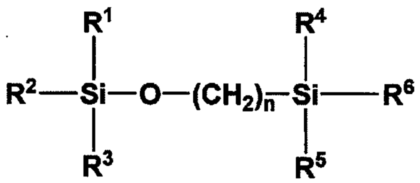

(1)

wherein $R^1$ to $R^6$ individually represent a hydrogen atom, an alkyl group having 1 to 4 carbon atoms, a vinyl group, a phenyl group, a halogen atom, a hydroxyl group, an acetoxy group, a phenoxy group, or an alkoxy group, provided that at least one of $R^1$ to $R^6$ represents a halogen atom, a hydroxyl group, an acetoxy group, a phenoxy group, or an alkoxy group, and n represents an integer from 0 to 3.

**10.** A method of producing an organosilicon compound shown by the general formula (1), the method comprising reacting a compound 1 shown by the following general formula (3) with a compound 2 shown by the following general formula (4) in an atmosphere that contains oxygen,

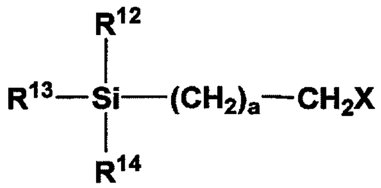

(3)

wherein $R^{12}$ to $R^{14}$ individually represent a hydrogen atom, an alkyl group having 1 to 4 carbon atoms, a vinyl group, a phenyl group, a halogen atom, a hydroxyl group, an acetoxy group, a phenoxy group, or an alkoxy group, X represents a halogen atom, and a represents an integer from 0 to 2,

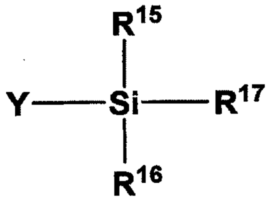

(4)

wherein at least one of $R^{15}$ to $R^{17}$ represents a hydrogen atom, an alkyl group having 1 to 4 carbon atoms, a vinyl group, a phenyl group, a halogen atom, a hydroxyl group, an acetoxy group, a phenoxy group, or an alkoxy group, at least one of $R^{15}$ to $R^{17}$ represents a halogen atom, a hydroxyl group, an acetoxy group, a phenoxy group, or an alkoxy group, and Y represents a halogen atom, a hydrogen atom, or an alkoxy group.

**INTERNATIONAL SEARCH REPORT**

International application No.
PCT/JP2008/052264

A. CLASSIFICATION OF SUBJECT MATTER
*C07F7/18*(2006.01)i, *C09D5/25*(2006.01)i, *C09D183/06*(2006.01)i, *C23C16/42*(2006.01)i, *H01L21/316*(2006.01)i

According to International Patent Classification (IPC) or to both national classification and IPC

B. FIELDS SEARCHED

Minimum documentation searched (classification system followed by classification symbols)
C07F7/18, C09D5/25, C09D183/06, C23C16/42, H01L21/316

Documentation searched other than minimum documentation to the extent that such documents are included in the fields searched

| | | | |
|---|---|---|---|
| Jitsuyo Shinan Koho | 1922-1996 | Jitsuyo Shinan Toroku Koho | 1996-2008 |
| Kokai Jitsuyo Shinan Koho | 1971-2008 | Toroku Jitsuyo Shinan Koho | 1994-2008 |

Electronic data base consulted during the international search (name of data base and, where practicable, search terms used)
CAplus(STN), REGISTRY(STN)

C. DOCUMENTS CONSIDERED TO BE RELEVANT

| Category* | Citation of document, with indication, where appropriate, of the relevant passages | Relevant to claim No. |
|---|---|---|
| X<br>A | JP 2005-294333 A (Kabushiki Kaisha Handotai Process Kenkyusho),<br>20 October, 2005 (20.10.05),<br>Claims; examples<br>& EP 1583142 A2 & US 2005/221622 A1 | 1-2,4-9<br>3,10 |
| X<br>Y<br>A | JAKOUBKOVA, M. et al., Organosilicon compounds. CXLI. Proton acceptor ability of halogens in organosilicon compounds, Collection of Czechoslovak Chemical Communications, 1976, 41(9), 2701-2707 | 9-10<br>10<br>1-8 |
| X<br>Y<br>A | JP 2005-255614 A (Shin-Etsu Chemical Co., Ltd.),<br>22 September, 2005 (22.09.05),<br>Claims; Par. Nos. [0010], [0011]; examples<br>(Family: none) | 9<br>10<br>1-8 |

☒ Further documents are listed in the continuation of Box C. ☐ See patent family annex.

* Special categories of cited documents:
"A" document defining the general state of the art which is not considered to be of particular relevance
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed
"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

Date of the actual completion of the international search
06 March, 2008 (06.03.08)

Date of mailing of the international search report
18 March, 2008 (18.03.08)

Name and mailing address of the ISA/
Japanese Patent Office

Facsimile No.

Authorized officer

Telephone No.

Form PCT/ISA/210 (second sheet) (April 2007)

**INTERNATIONAL SEARCH REPORT**

International application No.
PCT/JP2008/052264

C (Continuation). DOCUMENTS CONSIDERED TO BE RELEVANT

| Category* | Citation of document, with indication, where appropriate, of the relevant passages | Relevant to claim No. |
|---|---|---|
| X<br>Y<br>A | US 3529007 A (Rhone-Poulenc S.A.),<br>15 September, 1970 (15.09.70),<br>Claims; examples<br>& FR 1498641 A1 & DE 1668605 A1<br>& GB 1156257 A | 9<br>10<br>1-8 |
| X<br>Y<br>A | JP 11-322935 A (Nippon Unicar Co., Ltd.),<br>26 November, 1999 (26.11.99),<br>Examples<br>(Family: none) | 9<br>10<br>1-8 |

Form PCT/ISA/210 (continuation of second sheet) (April 2007)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- JP 11288931 A
- JP 2002329718 A
- JP 2002503879 T
- JP 2005513766 T
- JP 2004006607 A
- JP 2005051192 A